# DEMANDE DE BREVET EUROPEEN

(11) **EP 4 401 316 A1**
(43) Date de publication de la demande: **17.07.2024**
(21) Numéro de dépôt: 23215212.4
(22) Date de dépôt: 08.12.2023
(51) Int. Cl.: H03M 1/06, H03M 1/66

(54) **CIRCUIT INTÉGRÉ COMPRENANT UN CONVERTISSEUR NUMÉRIQUE-ANALOGIQUE**

(30) Priorité: 16.12.2022 FR 2213546
(71) Demandeur: STMicroelectronics International N.V., 1228 Plan-les-Ouates, Geneva (CH)
(72) Inventeur: BINET, Vincent, 13100 Aix-en-Provence (FR)
(74) Mandataire: Casalonga

(57) **Abrégé**

Selon un aspect, il est proposé un circuit intégré comprenant :
- un convertisseur numérique-analogique (MDAC) configuré pour convertir un mot numérique (DIGW) en un signal analogique (SDAC),
- un circuit de commutation comportant :
o un premier transistor (PMOS1) présentant un drain configuré pour recevoir le signal analogique (SDAC) et une source connectée à un drain d'un deuxième transistor (PMOS2),
o un troisième transistor (NMOS1) présentant un drain configuré pour recevoir le signal analogique (SDAC) et une source connectée à un drain d'un quatrième transistor (NMOS2),

- un circuit de contrôle de tensions configuré pour appliquer une tension sur la source du premier transistor (PMOS1) et sur la source du troisième transistor (NMOS1) de manière à limiter une tension drain-source du premier transistor (PMOS1) et une tension drain-source du troisième transistor (NMOS1) quelle que soit la valeur dudit mot numérique.

## Description

Des modes de réalisation concernent les circuits intégrés, et plus particulièrement ceux comprenant un convertisseur numérique-analogique.

Certains circuits intégrés sont utilisés pour contrôler des appareils électroniques. En particulier, les systèmes sur puce et les microcontrôleurs sont des circuits intégrés généralement utilisés dans des systèmes embarqués

De tels circuits intégrés comprennent généralement un convertisseur numérique-analogique. Un convertisseur numérique-analogique est un dispositif électronique permettant de convertir un signal numérique (c'est-à-dire codée sur plusieurs bits) en un signal analogique, notamment en une tension électrique.

Le signal analogique peut être utilisé pour différentes fonctionnalités. Par exemple, le signal analogique peut être utilisé pour commander un appareil électrique. L'appareil électrique peut notamment être un moteur ou un capteur. Le signal analogique peut également être transmis à d'autres composants électroniques internes du circuit intégré, tels qu'un comparateur, ou un convertisseur analogique-numérique ou peut être utilisé comme signal de référence.

Un circuit intégré peut présenter différents modes de fonctionnement permettant au convertisseur numérique-analogique d'adresser différentes fonctionnalités.

En particulier, le circuit intégré peut comprendre des commutateurs en sortie du convertisseur numérique-analogique pour chaque mode du circuit intégré. Par exemple, un premier commutateur peut être situé entre la sortie du convertisseur numérique-analogique est une sortie du circuit intégré configurée pour être connectée à un appareil électrique. Un deuxième commutateur peut être situé entre la sortie du convertisseur numérique-analogique et des éléments électroniques internes du circuit intégré.

Le circuit intégré comprend une unité de contrôle configurée pour fermer ou ouvrir les commutateurs en sortie du convertisseur numérique-analogique en fonction du mode de fonctionnement choisi. Par exemple, lorsque le convertisseur numérique-analogique est utilisé pour commander un appareil électronique, ledit premier commutateur est fermé et ledit deuxième commutateur est ouvert. À l'inverse, lorsque le convertisseur numérique-analogique est utilisé pour le fonctionnement d'un composant électronique interne du circuit intégré, le deuxième commutateur est fermé et le premier commutateur est ouvert.

Par ailleurs, certains circuits intégrés peuvent être employés pour des applications dans lesquelles ces circuits intégrés sont placés dans un environnement contraignant. En particulier, certaines applications imposent des températures aux circuits intégrés pouvant être comprises entre -40°C et 140°C. Ces températures peuvent impacter la précision des signaux analogiques en sortie des convertisseurs numérique-analogique. En effet, les hautes températures peuvent induire des fuites de courant impactant la valeur analogique du signal en sortie des convertisseurs numérique-analogique. Or, des fuites de courant peuvent être suffisamment élevées pour modifier la valeur du signal analogique en sortie du convertisseur numérique-analogique d'au moins un pas correspondant à un bit de poids faible de la valeur numérique.

En particulier, les fuites de courant les plus importantes proviennent du commutateur en sortie du convertisseur numérique-analogique dédié au mode de fonctionnement permettant de commander un appareil électronique. Les fuites de courant sont plus importantes lorsque le convertisseur numérique-analogique convertit les plus faibles valeurs numériques ou bien les plus fortes valeurs numériques. Plus particulièrement, ces fuites de courant apparaissent surtout lorsque ce commutateur est ouvert lorsque le mode de fonctionnement choisi est celui permettant de transmettre le signal analogique généré par le commutateur numérique-analogique à un élément électronique interne du circuit intégré.

Il existe donc un besoin de proposer une solution permettant de réduire les fuites de courant en sortie d'un convertisseur numérique-analogique

Selon un aspect, il est proposé un circuit intégré comprenant :
- un convertisseur numérique-analogique configuré pour convertir un mot numérique en un signal analogique,
- un circuit de commutation comportant :
   ∘ un premier transistor de type PMOS présentant un drain configuré pour recevoir le signal analogique et une source connectée à un drain d'un deuxième transistor de type PMOS,
   ∘ un troisième transistor de type NMOS présentant un drain configuré pour recevoir le signal analogique et une source connectée à un drain d'un quatrième transistor de type NMOS,
- un circuit de contrôle de tensions configuré pour appliquer une tension sur la source du premier transistor et sur la source du troisième transistor de manière à limiter une tension drain-source du premier transistor et une tension drain-source du troisième transistor quelle que soit la valeur dudit mot numérique.

Un tel circuit intégré permet de limiter la tension drain-source du premier transistor de type P et celle du troisième transistor de type N quelle que soit la tension du signal analogique généré par le convertisseur numérique-analogique.

Un tel circuit intégré permet ainsi de limiter les fuites de courant au travers du premier transistor de type P et du troisième transistor de type N quelle que soit la tension du signal analogique généré par le convertisseur numérique-analogique.

Le circuit intégré permet donc d'obtenir une conversion numérique-analogique robuste sur une large plage de températures, comprises entre -40°C et 140°C.

De préférence, le deuxième transistor de type PMOS et le quatrième transistor de type NMOS présentent chacun une source configurée pour pouvoir être connectée à un appareil électrique externe au circuit intégré.

Avantageusement, le circuit intégré comprend en outre un commutateur présentant une première borne configurée pour recevoir le signal analogique généré par le convertisseur numérique-analogique et une deuxième borne connectée électriquement à un élément électronique interne du circuit intégré.

Dans un mode de réalisation avantageux, le circuit intégré comprend en outre une unité de contrôle configurée pour commander le circuit de commutation et le commutateur selon un mode de fonctionnement afin de transmettre le signal analogique généré par le convertisseur numérique-analogique soit vers l'appareil électrique externe soit vers l'élément électronique interne du circuit intégré.

Un tel circuit intégré est configuré pour limiter les fuites de courant au travers du circuit de commutation lorsque ce circuit de commutation est ouvert et le commutateur connecté à un élément électronique interne du circuit intégré est fermé.

Avantageusement, le circuit de contrôle de tensions est configuré pour :
- appliquer une tension nulle sur la source du premier transistor de type PMOS lorsque la valeur du mot numérique est inférieure à un premier seuil, et une tension proche d'une tension du signal analogique sur la source du premier transistor lorsque la valeur du mot numérique est supérieure au premier seuil, de manière à limiter la tension drain-source du premier transistor quelle que soit la valeur dudit mot numérique,
- appliquer une tension proche d'une tension du signal analogique sur la source du troisième transistor de type NMOS lorsque la valeur du mot numérique est inférieure à un deuxième seuil, et une tension correspondant à une tension maximale délivrée par le convertisseur numérique-analogique sur la source du troisième transistor lorsque la valeur du mot numérique est supérieure au deuxième seuil, le deuxième seuil étant inférieur au premier seuil, de manière à limiter la tension drain-source du troisième transistor quelle que soit la valeur dudit mot numérique.

Dans un mode de réalisation, le circuit de contrôle de tensions comprend :
- un premier commutateur présentant une première borne connectée à la source du premier transistor et une deuxième borne connectée à la masse, ce commutateur étant contrôlé par un premier signal,
- un deuxième commutateur présentant une première borne connectée à la première borne du circuit de commutation et une deuxième borne connectée à la source du premier transistor, ce commutateur étant contrôlé par le premier signal,
- un troisième commutateur présentant une première borne connectée à la source du troisième transistor, et une deuxième borne configurée pour recevoir une tension correspondant à une tension maximale délivrée par le convertisseur numérique-analogique, ce commutateur étant contrôlé par un deuxième signal inversé,
- un quatrième commutateur présentant une première borne connectée à la première borne du circuit de commutation et une deuxième borne connectée à la source du troisième transistor, ce commutateur étant contrôlé par le deuxième signal,
- un circuit de commande configuré pour générer le premier signal et le deuxième signal en fonction de la valeur du mot numérique, de manière à limiter la tension drain-source du premier transistor et la tension drain-source du troisième transistor quelle que soit la valeur dudit mot numérique.

Dans un autre mode de réalisation, le circuit de contrôle de tension comprend :
- un premier commutateur présentant une première borne connectée à la source du premier transistor et une deuxième borne connectée à la masse, ce commutateur étant contrôlé par un premier signal,
- un premier amplificateur opérationnel présentant une entrée non inverseuse connectée à la première borne du circuit de commutation, une sortie connectée à la source du premier transistor et à une entrée inverseuse de ce premier amplificateur opérationnel, et une entrée d'alimentation commandée par le premier signal inversé,
- un deuxième commutateur présentant une première borne connectée à la source du troisième transistor, et une deuxième borne configurée pour recevoir une tension correspondant à une tension maximale délivrée par le convertisseur numérique-analogique, ce deuxième commutateur étant contrôlé par un deuxième signal inversé,

- un deuxième amplificateur opérationnel présentant une entrée non inverseuse connectée à la première borne du circuit de commutation, une sortie connectée à la source du troisième transistor et à une entrée inverseuse de ce deuxième amplificateur opérationnel, et une entrée d'alimentation commandée par le deuxième signal,
- un circuit de commande configuré pour générer le premier signal et le deuxième signal en fonction de la valeur du mot numérique, de manière à limiter la tension drain-source du premier transistor et la tension drain-source du troisième transistor quelle que soit la valeur dudit mot numérique.

Dans un autre mode de réalisation, le circuit de contrôle de tension comprend un convertisseur numérique-analogique auxiliaire configuré pour appliquer des tensions sur la source du premier transistor et sur la source du troisième transistor en fonction de la valeur du mot numérique de manière à limiter la tension drain-source du premier transistor et la tension drain-source du troisième transistor quelle que soit la valeur dudit mot numérique.

En particulier, le convertisseur numérique-analogique auxiliaire peut comprendre :
- un circuit diviseur de tension configuré pour générer des tensions proches de la tension correspondant à une tension maximale délivrée par le convertisseur numérique-analogique et des tensions proches de la masse,
- un premier groupe de commutateurs configuré pour appliquer lesdites tensions proches de la masse ou la tension maximale sur la source du premier transistor,
- un deuxième groupe de commutateurs configuré pour appliquer lesdites tensions proches de la tension maximale ou la tension de la masse sur la source du troisième transistor,
- un circuit de commande pour commander les commutateurs du convertisseur-analogique auxiliaire selon la valeur du mot numérique de manière à limiter la tension drain-source du premier transistor et la tension drain-source du troisième transistor quelle que soit la valeur dudit mot numérique.

En variante, le convertisseur numérique-analogique auxiliaire comprend :
- une première paire de commutateurs configurée pour appliquer une tension correspondant à une tension maximale délivrée par le convertisseur numérique-analogique ou une tension de masse sur la source du premier transistor,
- une deuxième paire de commutateurs configurée pour appliquer une tension maximale ou une tension de masse sur la source du troisième transistor,
- un circuit de commande pour commander les paires de commutateurs du convertisseur-analogique auxiliaire selon la valeur du mot numérique de manière à limiter la tension drain-source du premier transistor et la tension drain-source du troisième transistor quelle que soit la valeur dudit mot numérique.

D'autres avantages et caractéristiques de l'invention apparaîtront à l'examen de la description détaillée de modes de réalisation, nullement limitatifs, et des dessins annexés sur lesquels :
[Fig 1]
[Fig 2]
[Fig 3]
[Fig 4]
[Fig 5]
[Fig 6]
[Fig 7]
[Fig 8]
[Fig 9]

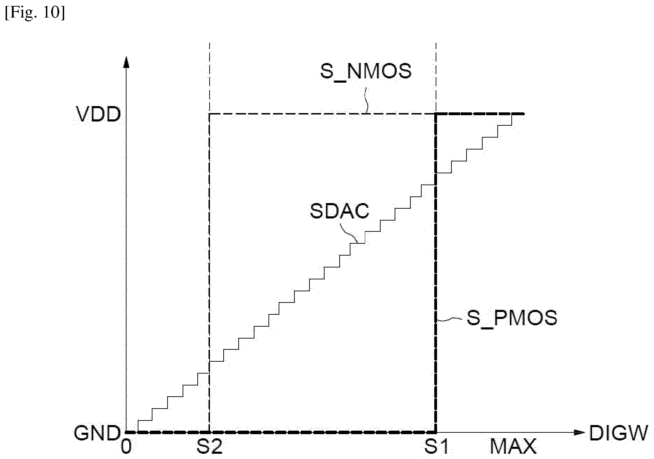

[Fig 10] illustrent des modes de réalisation et de mise en oeuvre de l'invention.

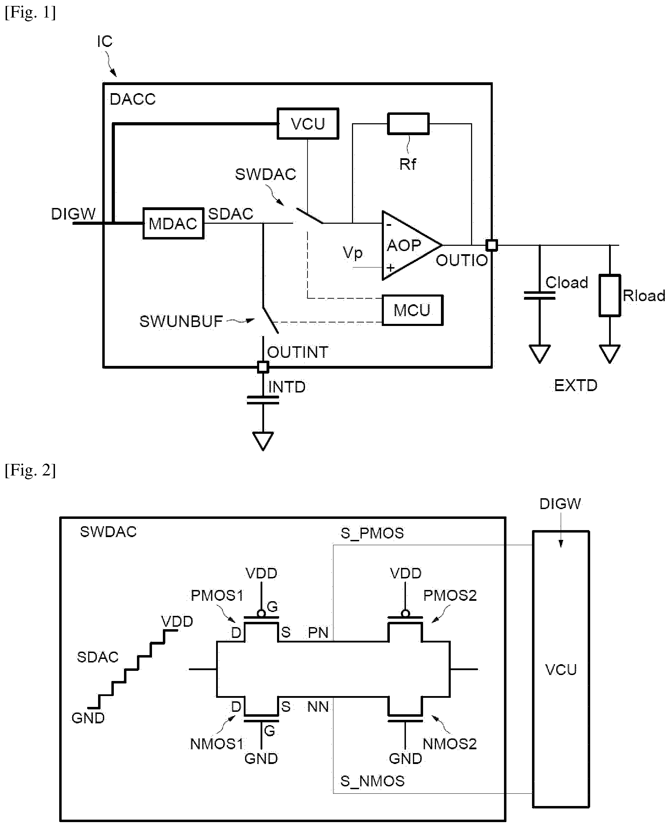

La figure 1 illustre un circuit intégré IC comprenant un circuit de conversion numérique-analogique DACC.

Le circuit de conversion numérique-analogique DACC comprend une entrée configurée pour recevoir un mot numérique DIGW.

Le circuit de conversion numérique-analogique comprend également plusieurs sorties. Une première sortie OUTIO est configurée pour être connectée à un appareil électrique externe EXTD au circuit intégré IC. Ici, l'appareil électrique présente une valeur capacitive Cload et une valeur résistive Rload. Par exemple, l'appareil électrique externe EXTD peut être un moteur électrique ou un capteur électronique.

Une deuxième sortie est configurée pour être connectée à un élément électronique interne INTD du circuit intégré IC. Par exemple, l'élément électronique INTD peut être comparateur ou un convertisseur-analogique-numérique.

Le circuit de conversion numérique-analogique DACC est configuré pour convertir le mot numérique DIGW qu'il reçoit en entrée en un signal analogique SDAC qu'il peut délivrer à l'une ou l'autre des sorties OUTIO, OUTINT en fonction d'un mode de fonctionnement choisi.

En particulier, le circuit de conversion numérique-analogique comprend en outre une unité de contrôle MCU configurée pour commander un mode de fonctionnement du circuit de conversion numérique-analogique DACC. Le mode de fonctionnement du circuit de conversion numérique-analogique DACC permet de choisir vers quelle sortie OUTIO, INTIO du circuit de conversion numérique-analogique DACC transmettre le signal analogique SDAC. Ainsi, le mode de fonctionnement permet de choisir de transmettre le signal analogique SDAC vers un appareil électrique externe EXTD ou bien vers un élément électronique interne INTD du circuit intégré IC.

Plus particulièrement, le signal analogique SDAC peut être utilisé pour différentes fonctionnalités. Par exemple, le signal analogique SDAC peut être utilisé pour commander l'appareil électrique EXTD. L'appareil électrique EXTD peut notamment être un moteur ou un capteur. Le signal analogique SDAC peut également être transmis à des éléments électroniques internes du circuit intégré, tels qu'un comparateur, ou un convertisseur analogique-numérique ou peut être utilisé comme signal de référence.

Le circuit de conversion numérique-analogique DACC comprend un convertisseur numérique-analogique MDAC. Le convertisseur numérique-analogique MDAC est configuré pour recevoir le mot numérique DIGW et pour générer le signal analogique SDAC selon ce mot numérique DIGW. Le convertisseur numérique-analogique MDAC peut être un convertisseur numérique-analogique de type résistif.

Le signal analogique SDAC généré par le convertisseur numérique-analogique MDAC présente une tension qui dépend de la valeur du mot numérique DIGW. Cette tension varie entre une tension nulle (0 Volt) et une tension VDD.

Le circuit de conversion numérique-analogique DACC comporte en outre un amplificateur opérationnel AOP monté en suiveur. En particulier, l'amplificateur AOP présente une entrée inverseuse configurée pour recevoir le signal analogique SDAC généré en sortie du convertisseur numérique-analogique MDAC. L'amplificateur AOP comprend également une entrée non inverseuse configurée pour recevoir une tension Vp. L'amplificateur AOP présente une sortie connectée à la première sortie OUTIO du circuit de conversion numérique-analogique DACC. Un élément résistif Rf présente une première borne connectée à l'entrée inverseuse de l'amplificateur AOP et une deuxième borne connectée à la sortie de l'amplificateur AOP. L'élément résistif Rf présente par exemple une valeur résistive comprise entre Rdac et N*Rdac, où Rdac correspond à une valeur d'une résistance unitaire de l'amplificateur AOP et N correspond à un gain souhaité pour l'amplificateur AOP. Par exemple, cette valeur résistive peut être comprise entre 100kΩ et 32*100kΩ. Un tel amplificateur AOP sert de tampon (en anglais « buffer ») entre la sortie du convertisseur numérique-analogique MDAC et la première sortie OUTIO du circuit de conversion numérique-analogique DACC.

Le circuit de conversion numérique-analogique DACC comporte également un circuit de commutation SWDAC. Le circuit de commutation SWDAC est placé entre la sortie du convertisseur numérique-analogique MDAC et l'entrée inverseuse de l'amplificateur AOP. Le circuit de commutation SWDAC présente donc une première borne connectée à la sortie du convertisseur numérique-analogique MDAC et une deuxième borne connectée à l'entrée inverseuse de l'amplificateur AOP. L'entrée inverseuse de l'amplificateur AOP est ainsi configurée pour recevoir le signal analogique SDAC généré en sortie du convertisseur numérique-analogique MDAC par l'intermédiaire du circuit de commutation SWDAC, lorsque ce dernier est fermé. En particulier, le circuit de commutation SWDAC est configuré pour être fermé lorsque le mode de fonctionnement choisi est celui utilisé pour transmettre le signal analogique SDAC généré par le convertisseur numérique-analogique MDAC à la première sortie OUTIO du circuit de conversion numérique-analogique DACC vers un appareil électrique externe EXTD du circuit intégré IC. Le circuit de commutation SWDAC est configuré pour être ouvert lorsqu'un autre mode de fonctionnement est choisi.

Le circuit de conversion numérique-analogique DACC comporte également un commutateur SWUNBUF. Le commutateur SWUNBUF présente une première borne connectée à la sortie du convertisseur numérique-analogique MDAC et une deuxième borne connectée à la deuxième sortie OUTINT du circuit de conversion numérique-analogique DACC. Le commutateur SWUNBUF est configuré pour être fermé lorsque le mode de fonctionnement choisi est celui utilisé pour transmettre le signal analogique SDAC généré par le convertisseur numérique-analogique MDAC à la deuxième sortie OUTINT du circuit de conversion numérique-analogique DACC vers un élément électronique interne INTD du circuit intégré IC. Le commutateur SWUNBUF est configuré pour être ouvert lorsqu'un autre mode de fonctionnement est choisi.

Comme illustré à la figure 2, le circuit de commutation SWDAC comprend deux transistors PMOS1, PMOS2 de type PMOS montés en série. Un transistor de type PMOS est un transistor à effet de champ à grille isolée à canal de type P. Le circuit de commutation SWDAC comprend également deux transistors NMOS1, NMOS2 de type NMOS montés en série. Un transistor de type NMOS est un transistor à effet de champ à grille isolée à canal de type N. Les transistors PMOS 1, PMOS2 et les transistors NMOS 1, NMOS2 sont montés en parallèle entre les deux bornes du circuit de commutation SWDAC.

Les transistors PMOS1, PMOS2 présentent une grille G configurée pour être commandée par l'unité de contrôle MCU avec une tension VDD pour les fermer. Le transistor PMOS 1 présente un drain connecté à la première borne du circuit de commutation de façon à pouvoir recevoir le signal analogique SDAC généré par le convertisseur numérique-analogique MDAC, et une source connectée à un drain du transistor PMOS2. Le transistor PMOS2 présente une source connectée à la deuxième borne du circuit de commutation SWDAC.

Les transistors NMOS1, NMOS2 présentent une grille G configurée pour être commandée par l'unité de contrôle MCU avec une tension GND pour les fermer. Le transistor NMOS1 présente un drain connecté à la première borne du circuit de commutation de façon à pouvoir recevoir le signal analogique SDAC généré par le convertisseur numérique-analogique MDAC, et une source connectée à un drain du transistor NMOS2. Le transistor NMOS2 présente une source connectée à la deuxième borne du circuit de commutation SWDAC.

Le circuit de conversion numérique-analogique DACC comprend également un circuit de contrôle de tensions VCU. Le circuit de contrôle de tensions VCU est configuré pour appliquer certaines tensions sur un noeud PN entre les transistors PMOS1, PMOS2 et sur un noeud NN entre les transistors NMOS 1, NMOS2 selon la valeur du mot numérique DIGW en entrée du circuit de conversion numérique-analogique DACC. Le circuit de contrôle de tensions VCU est utilisé afin de réduire les fuites de courant au travers des transistors PMOS 1 et NMOS 1 lorsque le circuit de commutation SWDAC est ouvert, notamment lorsque le mode de fonctionnement choisi permet de transmettre le signal analogique SDAC à un élément électronique interne INTD du circuit intégré.

Le circuit de contrôle de tensions VCU est configuré pour appliquer une tension GND sur le noeud PN entre les transistors PMOS 1, PMOS2 lorsque la valeur du mot numérique DIGW est inférieure à un premier seuil donné, et pour appliquer une tension proche d'une tension VDD lorsque la valeur du mot numérique DIGW est supérieure à ce premier seuil de façon à réduire la tension VDS du transistor PMOS1. Ce premier seuil est choisi en fonction des performances souhaitées du circuit de conversion numérique-analogique DACC. En particulier, ce premier seuil est choisi afin de limiter les fuites de courant au travers du transistor PMOS1, lorsque la valeur du mot numérique DIGW est supérieure au premier seuil donné. En effet, un tel contrôle de la tension au noeud PN entre les transistors PMOS 1 et PMOS2 permet de réduire la tension drain-source du transistor PMOS 1 lorsque la tension du signal analogique SDAC généré par le convertisseur numérique-analogique MDAC est proche de VDD (c'est-à-dire lorsque la valeur du mot numérique DIGW est proche de sa valeur maximale MAX). La tension drain-source du transistor PMOS1 est donc toujours faible quelle que soit la tension du signal analogique généré par le convertisseur numérique-analogique MDAC. En outre, le fait de forcer le noeud PN à la tension GND lorsque la valeur du mot numérique DIGW est inférieure au premier seuil permet de bloquer correctement les transistors PMOS1 et PMOS2, de manière à isoler correctement la sortie OUTINT de la sortie OUTIO.

Le circuit de contrôle de tensions VCU est configuré pour appliquer une tension proche de la masse GND sur le noeud NN entre les transistors NMOS1, NMOS2 lorsque la valeur du mot numérique DIGW est inférieure à un deuxième seuil donné de façon à réduire la tension VDS du transistor NMOS1, et pour appliquer une tension VDD lorsque la valeur du mot numérique DIGW est supérieure à ce deuxième seuil. Ce deuxième seuil est inférieur au premier seuil. Ce deuxième seuil est choisi en fonction des performances souhaitées du circuit de conversion numérique-analogique DACC. En particulier, ce deuxième seuil est choisi afin de limiter les fuites de courant au travers du transistor NMOS1, lorsque la valeur du mot numérique DIGW est inférieure au deuxième seuil donné. En effet, un tel contrôle de la tension au noeud NN entre les transistors NMOS1 et NMOS2 permet de réduire la tension drain-source du transistor NMOS1 lorsque la tension du signal analogique SDAC généré par le convertisseur numérique-analogique MDAC est proche de GND (c'est-à-dire lorsque la valeur du mot numérique DIGW est proche de sa valeur minimale). La tension drain-source du transistor NMOS1 est donc toujours faible quelle que soit la tension du signal analogique SDAC généré par le convertisseur numérique-analogique MDAC. En outre, le fait de forcer le noeud NN à la tension VDD lorsque la valeur du mot numérique DIGW est supérieur au deuxième seuil permet de bloquer correctement les transistors NMOS1 et NMOS2, de manière à isoler correctement la sortie OUTINT de la sortie OUTIO.

Un tel circuit de commutation SWDAC permet ainsi une bonne isolation par rapport à l'appareil électrique externe EXTD.

Un tel circuit de commutation SWDAC est également robuste sur une plage importante de températures, notamment entre -40°C et 140°C, du fait du contrôle des tensions aux noeuds NN et PN qui permet de limiter les fuites de courant.

Le circuit de contrôle de tensions VCU peut être réalisé selon différents modes de réalisation.

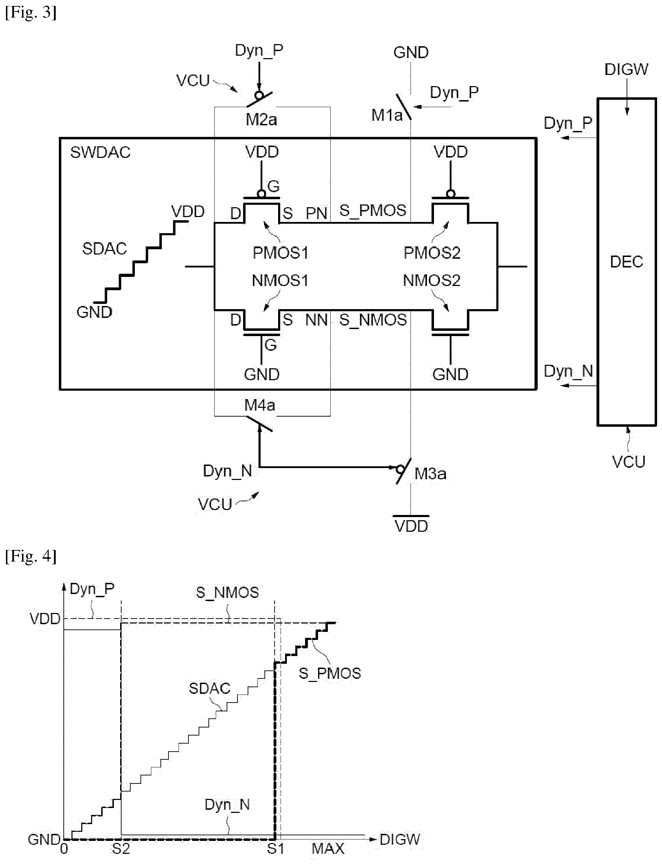

La figure 3 illustre un premier mode de réalisation d'un circuit de contrôle de tensions VCU.

Ce circuit de contrôle de tensions VCU comprend un premier commutateur M1a présentant une première borne connectée au noeud PN entre la source S du transistor PMOS1 et le drain D du transistor PMOS2, et une deuxième borne connectée à la masse GND. Ce commutateur M1a est contrôlé par un signal Dyn_P. De la sorte, le commutateur M1a est configuré pour être fermé lorsque le signal Dyn_P est dans un état haut, et ouvert lorsque le signal Dyn_P est dans un état bas.

Le circuit de contrôle de tensions VCU comprend également un deuxième commutateur M2a présentant une première borne connectée à la première borne du circuit de commutation SWDAC et une deuxième borne connectée au noeud PN entre les transistors PMOS1 et PMOS2. Ce commutateur M2a est contrôlé par l'inverse du signal Dyn_P. De la sorte, le commutateur M2a est configuré pour être ouvert lorsque le signal Dyn_P est dans un état haut, et fermé lorsque le signal Dyn_P est dans un état bas.

Le circuit de contrôle de tension VCU comprend également un troisième commutateur M3a présentant une première borne connectée au noeud NN entre la source S du transistor NMOS1 et le drain D du transistor NMOS2, et une deuxième borne configurée pour recevoir la tension VDD. Ce commutateur M3a est contrôlé par l'inverse d'un signal Dyn_N. De la sorte, le commutateur M3a est configuré pour être ouvert lorsque le signal Dyn_N est dans un état haut, et fermé lorsque le signal Dyn_N est dans un état bas.

Le circuit de contrôle de tensions VCU comprend également un quatrième commutateur M4a présentant une première borne connectée à la première borne du circuit de commutation SWDAC et une deuxième borne connectée au noeud NN entre les transistors NMOS1 et NMOS2. Ce commutateur M4a est contrôlé par le signal Dyn_N. De la sorte, le commutateur M4a est configuré pour être fermé lorsque le signal Dyn_N est dans un état haut, et ouvert lorsque le signal Dyn_N est dans un état bas.

Le circuit de contrôle de tensions VCU comprend également un circuit de commande DEC configuré pour générer les signaux Dyn_P et Dyn_N en fonction de la valeur du mot numérique DIGW reçu en entrée du circuit de conversion numérique-analogique. Le circuit de commande DEC présente donc une entrée configurée pour recevoir le mot numérique DIGW, et deux sorties configurées pour délivrer respectivement les signaux Dyn_P et Dyn_N.

En particulier, le signal Dyn_P est mis à l'état haut lorsque la valeur du mot numérique DIGW est inférieure à un seuil S1. Le signal Dyn_P est mis à l'état bas lorsque la valeur du mot numérique DIGW est supérieure au seuil S1. Le signal Dyn_N est mis à l'état haut lorsque la valeur du mot numérique DIGW est inférieure à un seuil S2. Le signal Dyn_N est mis à l'état bas lorsque la valeur du mot numérique DIGW est supérieure au seuil S2.

Ainsi, le noeud PN entre les transistors PMOS1 et PMOS2 est mis à la masse GND lorsque la valeur du mot numérique DIGW est inférieure au seuil S1, et est mis à la tension du signal analogique SWDAC généré par le convertisseur analogique-numérique MDAC lorsque la valeur du mot numérique DIGW est supérieure au seuil S1.

Le noeud NN entre les transistors NMOS 1 et NMOS2 est mis à la tension du signal analogique SDAC généré par le convertisseur analogique-numérique MDAC lorsque la valeur du mot numérique DIGW est inférieure au seuil S2, et est mis à la tension VDD lorsque la valeur du mot numérique DIGW est supérieure au seuil S2.

La figure 4 illustre un graphique montrant la valeur de la tension au noeud PN entre les transistors PMOS1 et PMOS2 et de la tension au noeud NN entre les transistors NMOS1 et NMOS2 en fonction de la valeur du mot numérique DIGW reçu en entrée du circuit de conversion numérique-analogique DACC.

En particulier, la courbe SDAC illustre la tension du signal analogique SDAC en sortie du convertisseur numérique-analogique MDAC. La courbe S_PMOS illustre la valeur de la tension au noeud PN entre les transistors PMOS1 et PMOS2 en fonction de la valeur du mot numérique DIGW, et la courbe S_NMOS illustre la valeur de la tension au noeud NN entre les transistors NMOS1 et NMOS2 en fonction de la valeur du mot numérique DIGW. La courbe Dyn_P illustre la valeur du signal Dyn_P en fonction de la valeur du mot numérique DIGW, et la courbe Dyn_N illustre la valeur du signal Dyn_N en fonction de la valeur du mot numérique DIGW.

La valeur de la tension du signal Dyn_P est égale à VDD lorsque la valeur du mot numérique DIGW est supérieure au seuil S1, et à la masse GND lorsque la valeur du mot numérique DIGW est supérieure au seuil S1.

Ainsi, la valeur de la tension au noeud PN entre les transistors PMOS1 et PMOS2 est égale à la masse lorsque la valeur du mot numérique DIGW est inférieure au seuil S1 du mot numérique DIGW, et à la valeur de la tension du signal analogique SDAC générée en sortie du convertisseur numérique-analogique MDAC lorsque la valeur du mot numérique DIGW est supérieure au seuil S1.

La valeur de la tension du signal Dyn_N est égale à VDD la valeur du mot numérique est inférieure au seuil S2 du mot numérique DIGW, et à la masse lorsque la valeur du mot numérique DIGW est supérieure au seuil S2.

Ainsi, la valeur de la tension au noeud NN entre les transistors NMOS1 et NMOS2 est égale à la valeur de la tension du signal analogique SDAC générée en sortie du convertisseur numérique-analogique MDAC lorsque la valeur du mot numérique DIGW est inférieure au seuil S2, et à la tension VDD lorsque la valeur du mot numérique DIGW est supérieure au seuil S2.

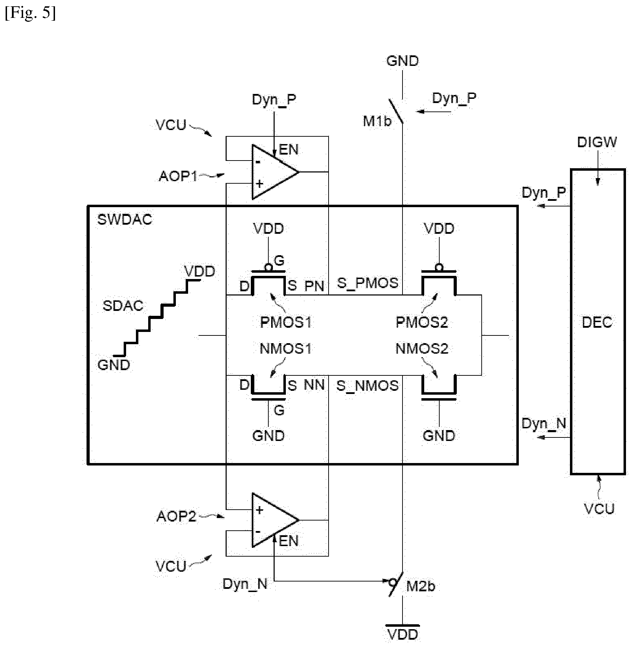

La figure 5 illustre un deuxième mode de réalisation d'un circuit de contrôle de tensions VCU. Le circuit de contrôle de tensions VCU comporte le même circuit de commande DEC décrit précédemment. Ce circuit de commande DEC est donc utilisé pour générer les signaux Dyn_P et Dyn_N de la même manière que décrit précédemment.

Le circuit de contrôle de tensions VCU comprend un premier commutateur M1b présentant une première borne connectée au noeud PN entre la source du transistor PMOS1 et le drain du transistor PMOS2, et une deuxième borne connectée à la masse GND. Ce commutateur M1b est contrôlé par un signal Dyn_P. De la sorte, le commutateur M1b est configuré pour être fermé lorsque le signal Dyn_P est dans un état haut, et ouvert lorsque le signal Dyn_P est dans un état bas.

Le circuit de contrôle de tensions VCU comprend également un premier amplificateur opérationnel AOP1. Ce premier amplificateur opérationnel AOP1 présente une entrée non inverseuse connectée à la première borne du circuit de commutation SWDAC, une sortie connectée au noeud PN entre les transistors PMOS1 et PMOS2, et à une entrée inverseuse de ce premier amplificateur opérationnel AOP1. Le premier amplificateur opérationnel AOP1 présente une entrée d'alimentation commandée par le signal Dyn_P. En particulier, le premier amplificateur opérationnel AOP1 est alimenté lorsque le signal Dyn_P est à l'état bas.

Le circuit de contrôle de tensions VCU comprend également un deuxième commutateur M2b présentant une première borne connectée au noeud NN entre la source du transistor NMOS1 et le drain du transistor NMOS2, et une deuxième borne configurée pour recevoir la tension VDD. Ce commutateur M2b est contrôlé par l'inverse du signal Dyn_N. De la sorte, le commutateur M2b est configuré pour être ouvert lorsque le signal Dyn_N est dans un état haut, et fermé lorsque le signal Dyn_N est dans un état bas.

Le circuit de contrôle de tensions VCU comprend également un deuxième amplificateur opérationnel AOP2. Ce deuxième amplificateur opérationnel AOP2 présente une entrée non inverseuse connectée à la première borne du circuit de commutation SWDAC, une sortie connectée au noeud entre les transistors NMOS1 et NMOS2, et à une entrée inverseuse de ce deuxième amplificateur opérationnel AOP2. Le deuxième amplificateur opérationnel AOP2 présente une entrée d'alimentation EN commandée par le signal Dyn_N. En particulier, le deuxième amplificateur opérationnel AOP2 est alimenté lorsque le signal Dyn_N est à l'état haut.

La valeur de la tension du signal Dyn_P est égale à VDD lorsque la valeur du mot numérique DIGW est supérieure au seuil S1, et à la masse GND lorsque la valeur du mot numérique DIGW est supérieure au seuil S1.

Ainsi, la valeur de la tension au noeud PN entre les transistors PMOS1 et PMOS2 est égale à la masse lorsque la valeur du mot numérique DIGW est inférieure au seuil S1, et à la valeur de la tension du signal analogique SDAC générée en sortie du convertisseur numérique-analogique MDAC lorsque la valeur du mot numérique DIGW est supérieure au seuil S1.

La valeur de la tension du signal Dyn_N est égale à VDD lorsque la valeur du mot numérique est inférieure au seuil S2 du mot numérique DIGW, et à la masse lorsque la valeur du mot numérique DIGW est supérieure au seuil S2.

Ainsi, la valeur de la tension au noeud NN entre les transistors NMOS1 et NMOS2 est égale à la valeur de la tension du signal analogique SDAC générée en sortie du convertisseur numérique-analogique MDAC lorsque la valeur du mot numérique DIGW est inférieure au seuil S2, et à la tension VDD lorsque la valeur du mot numérique DIGW est supérieure au seuil S2.

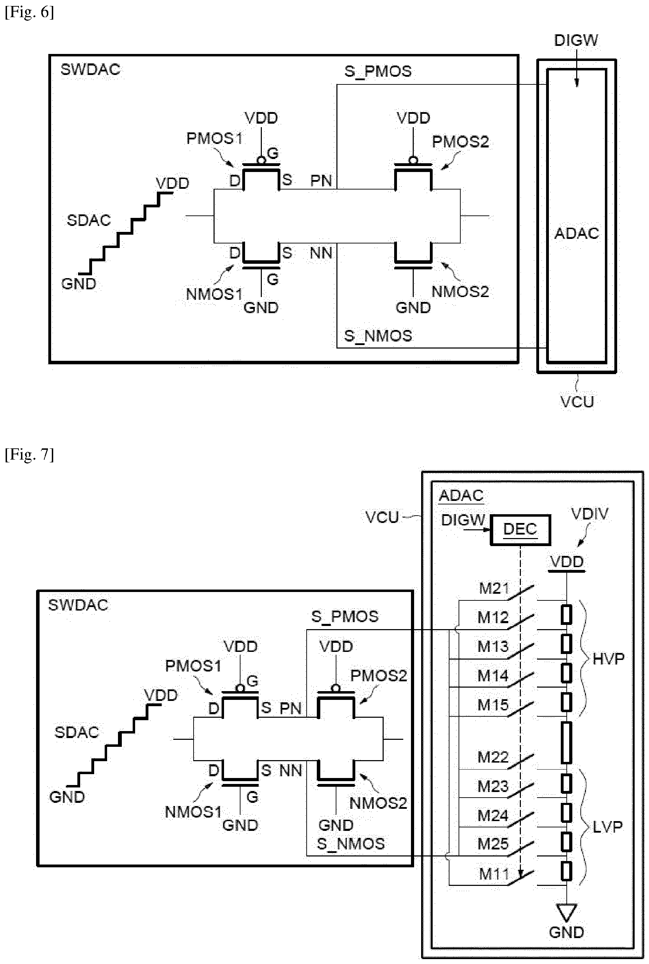

La figure 6 illustre un troisième mode de réalisation d'un circuit de contrôle de tensions VCU. Dans ce mode de réalisation, le circuit de contrôle de tensions VCU comporte un convertisseur numérique-analogique auxiliaire ADAC. Ce convertisseur numérique-analogique auxiliaire ADAC est simplifié par rapport au convertisseur numérique-analogique MDAC car il comporte des éléments résistifs de plus faibles valeurs par rapport à des éléments résistifs du convertisseur numérique-analogique MDAC. En effet, le convertisseur numérique-analogique auxiliaire ADAC ne requiert pas d'être autant précis que le convertisseur numérique-analogique MDAC. Ainsi, le convertisseur numérique-analogique auxiliaire ADAC est moins contraint par rapport à sa précision et peut donc être simplifié.

En particulier, le convertisseur numérique-analogique auxiliaire ADAC présente une entrée configurée pour recevoir le mot numérique DIGW reçu entrée du circuit de conversion numérique-analogique DACC.

Le convertisseur numérique-analogique auxiliaire ADAC est configuré pour appliquer certaines tensions sur le noeud PN entre les transistors PMOS1 et PMOS2 et sur le noeud NN entre les transistors NMOS1 et NMOS2 en fonction de la valeur du mot numérique DIGW reçu entrée.

Le convertisseur numérique-analogique auxiliaire ADAC peut être réalisé selon différents modes de réalisation.

La figure 7 illustre un premier mode de réalisation du convertisseur numérique-analogique auxiliaire ADAC.

Le convertisseur numérique-analogique auxiliaire ADAC comporte un circuit diviseur de tension VDIV. Le circuit diviseur de tension VDIV comprend plusieurs résistances en série. Le circuit diviseur de tension VDIV présente une première borne configurée pour recevoir la tension VDD et une deuxième borne connectée à la masse GND.

Le circuit diviseur de tension VDIV présente une partie, dite partie haute tension HVP, comprenant un groupe de résistance permettant de générer des tensions proches de la tension VDD, par exemple comprise entre VDD-50mV et VDD. En particulier, les tensions obtenues par la partie haute tension HVP correspondent aux tensions du signal analogique généré par le convertisseur numérique-analogique MDAC lorsque la valeur du mot numérique DIGW est supérieure à un premier seuil.

Le circuit diviseur de tension VDIV présente une partie, dite partie basse tension LVP, comprenant un groupe de résistance permettant de générer des tensions proches de la masse GND, par exemple comprise entre 0V et 50mV. En particulier, les tensions obtenues par la partie basse tension LVP correspondent aux tensions du signal analogique généré par le convertisseur numérique-analogique MDAC lorsque la valeur du mot numérique DIGW est inférieure à un deuxième seuil, ce deuxième seuil étant inférieur au premier seuil.

Le convertisseur numérique-analogique auxiliaire ADAC comporte en outre plusieurs commutateurs M11, M12, M13, M14, M15 et M21, M22, M23, M24, M25 présentant chacun une première borne connectée au circuit diviseur de tension VDIV et une deuxième borne connectée au noeud PN entre les transistors PMOS1 et PMOS2 ou au noeud NN entre les transistors NMOS1 et NMOS2. En particulier, un premier groupe de commutateurs comporte les commutateurs M11, M12, M13, M14, M15 présentant leur deuxième borne connectée au noeud PN entre les transistors PMOS1 et PMOS2 et un deuxième groupe de commutateurs comporte les commutateurs M21, M22, M23, M24, M25 présentant leur deuxième borne connectée au noeud NN entre les transistors NMOS1 et NMOS2.

Plus particulièrement, le premier groupe de commutateurs comporte un commutateur M11 présentant une première borne connectée à la masse GND et des commutateurs M12, M13, M14, M15 présentant une première borne connectée à des noeuds de la partie haute tension HVP du circuit diviseur de tension VDIV. Le deuxième groupe de commutateurs comporte un commutateur M21 présentant une première borne configurée pour recevoir la tension VDD et des commutateurs M22, M23, M24, M25 présentant une première borne connectée à des noeuds de la partie basse tension LVP du circuit diviseur de tension VDIV.

Le premier groupe de commutateurs est commandé en fonction de la tension qui doit être appliquée sur le noeud PN entre les transistors PMOS1 et PMOS2 et le deuxième groupe de commutateurs est commandé en fonction de la tension qui doit être appliquée sur le noeud NN entre les transistors NMOS1 et NMOS2.

En particulier, le convertisseur numérique-analogique auxiliaire ADAC comprend un circuit de commande DEC présentant une entrée configurée pour recevoir le mot numérique DIGW reçu en entrée du circuit de conversion numérique-analogique DACC. Le circuit de commande DEC est configuré pour commander les commutateurs du convertisseur-analogique auxiliaire ADAC selon la valeur du mot numérique DIGW qu'il reçoit de façon à appliquer des tensions souhaitées sur le noeud entre les transistors PMOS1 et PMOS2 et sur le noeud entre les transistors NMOS 1 et NMOS2.

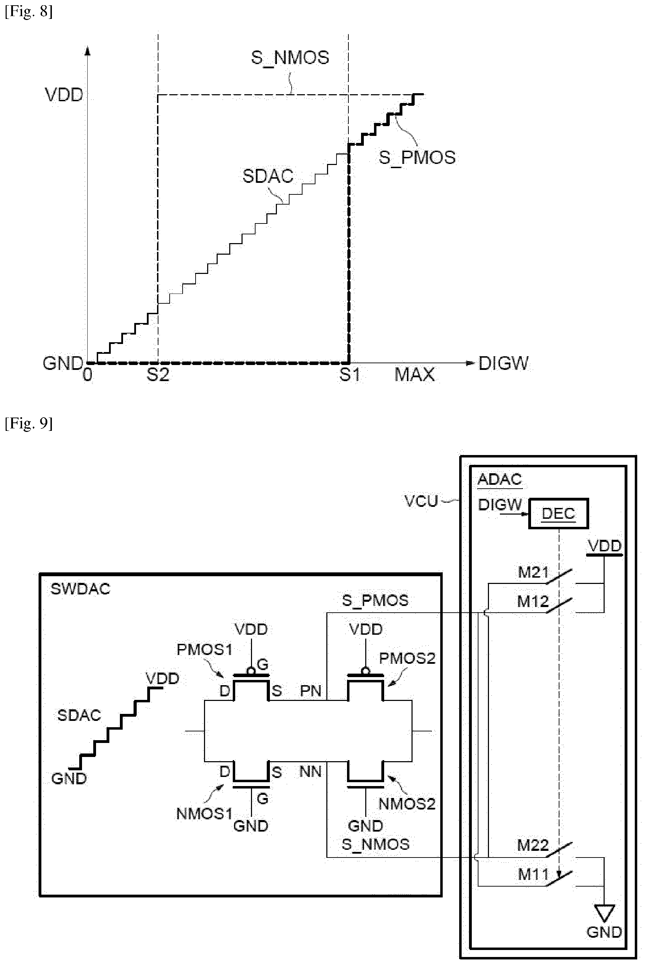

La figure 8 illustre un graphique montrant les tensions appliquées sur le noeud PN entre les transistors PMOS1 et PMOS2 et sur le noeud NN entre les transistors NMOS1 et NMOS2 par le convertisseur numérique analogique auxiliaire ADAC décrit en relation avec la figure 7 en fonction de la valeur du mot numérique DIGW reçu en entrée du circuit de conversion numérique-analogique DACC.

La courbe SDAC illustre la tension du signal analogique SDAC en sortie du convertisseur numérique-analogique MDAC.

La courbe S_PMOS illustre la tension appliquée sur le noeud PN entre les transistors PMOS1 et PMOS2 par le convertisseur numérique-analogique auxiliaire ADAC en fonction de la valeur du mot numérique DIGW reçu en entrée du circuit de conversion numérique-analogique DACC.

La courbe S_NMOS illustre la tension appliquée sur le noeud NN entre les transistors NMOS 1 et NMOS2 par le convertisseur numérique-analogique auxiliaire ADAC en fonction de la valeur du mot numérique DIGW reçu en entrée du circuit de conversion numérique-analogique DACC.

En particulier, les commutateurs M11, M12, M13, M14, M15 du premier groupe de commutateurs sont commandés de sorte que la valeur de la tension au noeud PN entre les transistors PMOS1 et PMOS2 soit égale à la masse GND lorsque la valeur du mot numérique DIGW est inférieure au seuil S1, et à une valeur correspondant à la valeur de la tension du signal analogique SDAC généré en sortie du convertisseur numérique-analogique MDAC lorsque la valeur du mot numérique DIGW est supérieure au seuil S1.

Les commutateurs M21, M22, M23, M24, M25 du deuxième groupe de commutateurs sont commandés de sorte que la valeur de la tension au noeud NN entre les transistors NMOS1 et NMOS2 soit égale à une valeur correspondant à la valeur de la tension du signal analogique SDAC généré en sortie du convertisseur numérique-analogique MDAC lorsque la valeur du mot numérique DIGW est inférieure au seuil S2, et à la tension VDD lorsque la valeur du mot numérique DIGW est supérieure au seuil S2.

La figure 9 illustre un deuxième mode de réalisation du convertisseur numérique-analogique auxiliaire ADAC. Le convertisseur numérique-analogique auxiliaire ADAC comporte deux paires de commutateurs M11, M12 et M21, M22.

Une première paire de commutateurs comprend un premier commutateur M11 présentant une première borne connectée à la masse GND et une deuxième borne connectée au noeud PN entre les transistors PMOS1 et PMOS2.

Cette première paire de commutateurs M11, M12 comprend également un deuxième commutateur M12 présentant une première borne configurée pour recevoir la tension VDD et une deuxième borne connectée au noeud PN entre les transistors PMOS1 et PMOS2.

Une deuxième paire de commutateurs comprend un premier commutateur M21 présentant une première borne configurée pour recevoir la tension VDD et une deuxième borne connectée au noeud NN entre les transistors NMOS1 et NMOS2.

Cette deuxième paire de commutateurs M11, M12 comprend également un deuxième commutateur M22 présentant une première borne connectée à la masse GND et une deuxième borne connectée au noeud NN entre les transistors NMOS1 et NMOS2.

La première paire de commutateurs M21, M22 est commandée en fonction de la tension qui doit être appliquée sur le noeud PN entre les transistors PMOS1 et PMOS2 et la deuxième paire de commutateurs est commandée en fonction de la tension qui doit être appliquée sur le noeud NN entre les transistors NMOS1 et NMOS2.

En particulier, le convertisseur numérique-analogique auxiliaire ADAC comprend un circuit de commande DEC présentant une entrée configurée pour recevoir le mot numérique DIGW reçu en entrée du circuit de conversion numérique-analogique DACC. Le circuit de commande DEC est configuré pour commander les commutateurs M11, M12 et M21, M22 du convertisseur-analogique auxiliaire ADAC selon la valeur du mot numérique DIGW qu'il reçoit de façon à appliquer des tensions souhaitées sur le noeud PN entre les transistors PMOS1 et PMOS2 et sur le noeud NN entre les transistors NMOS1 et NMOS2.

La figure 10 illustre un graphique montrant les tensions appliquées sur le noeud PN entre les transistors PMOS1 et PMOS2 et sur le noeud NN entre les transistors NMOS1 et NMOS2 par le convertisseur numérique analogique auxiliaire ADAC décrit en relation avec la figure 9 en fonction de la valeur du mot numérique DIGW reçu en entrée du circuit de conversion numérique-analogique DACC.

La courbe SDAC illustre la tension du signal analogique SDAC en sortie du convertisseur numérique-analogique MDAC.

La courbe S_PMOS illustre la tension appliquée sur le noeud PN entre les transistors PMOS1 et PMOS2 par le convertisseur numérique-analogique auxiliaire ADAC en fonction de la valeur du mot numérique DIGW reçu en entrée du circuit de conversion numérique-analogique DACC.

La courbe S_NMOS illustre la tension appliquée sur le noeud NN entre les transistors NMOS 1 et NMOS2 par le convertisseur numérique-analogique auxiliaire ADAC en fonction de la valeur du mot numérique DIGW reçu en entrée du circuit de conversion numérique-analogique DACC.

En particulier, les commutateurs M11, M12 du premier groupe de commutateurs sont commandés de sorte que la valeur de la tension au noeud PN entre les transistors PMOS1 et PMOS2 soit égale à la masse GND lorsque la valeur du mot numérique DIGW est inférieure au seuil S1, et à la tension VDD lorsque la valeur du mot numérique DIGW est supérieure au seuil S1.

Les commutateurs M21, M22 du deuxième groupe de commutateurs sont commandés de sorte que la valeur de la tension au noeud NN entre les transistors NMOS1 et NMOS2 soit égale à une valeur égale à la masse GND lorsque la valeur du mot numérique DIGW est inférieure au seuil S1, et à la tension VDD lorsque la valeur du mot numérique DIGW est supérieure au seuil S2.

## Revendications

1. Circuit intégré comprenant :
- un convertisseur numérique-analogique (MDAC) configuré pour convertir un mot numérique (DIGW) en un signal analogique (SDAC),
- un circuit de commutation comportant :
∘ un premier transistor (PMOS1) de type PMOS présentant un drain configuré pour recevoir le signal analogique (SDAC) et une source connectée à un drain d'un deuxième transistor (PMOS2) de type PMOS,
∘ un troisième transistor (NMOS1) de type NMOS présentant un drain configuré pour recevoir le signal analogique (SDAC) et une source connectée à un drain d'un quatrième transistor (NMOS2) de type NMOS,
- un circuit de contrôle de tensions configuré pour appliquer une tension sur la source du premier transistor (PMOS 1) et sur la source du troisième transistor (NMOS1) de manière à limiter une tension drain-source du premier transistor (PMOS1) et une tension drain-source du troisième transistor (NMOS1) quelle que soit la valeur dudit mot numérique.

2. Circuit intégré selon la revendication 1 dans lequel le deuxième transistor (PMOS2) de type PMOS et le quatrième transistor (NMOS2) de type NMOS présentent chacun une source configurée pour pouvoir être connectée à un appareil électrique externe (EXTD) au circuit intégré.

3. Circuit intégré selon l'une quelconque des revendications 1 ou 2, comprenant en outre un commutateur (SWUNBUF) présentant une première borne configurée pour recevoir le signal analogique (SDAC) généré par le convertisseur numérique-analogique (MDAC) et une deuxième borne connectée électriquement à un élément électronique interne du circuit intégré (INTD).

4. Circuit intégré selon la revendication 3, comprenant en outre une unité de contrôle configurée pour commander le circuit de commutation (SWDAC) et le commutateur selon un mode de fonctionnement afin de transmettre le signal analogique (SDAC) généré par le convertisseur numérique-analogique soit vers l'appareil électrique externe (EXTD) soit vers l'élément électronique interne (INTD) du circuit intégré.

5. Circuit intégré selon l'une des revendications 1 à 4, dans lequel le circuit de contrôle de tensions est configuré pour :
- appliquer une tension nulle sur la source du premier transistor (PMOS1) de type PMOS (PN) lorsque la valeur du mot numérique (DIGW) est inférieure à un premier seuil (S1), et une tension proche d'une tension du signal analogique (SDAC) sur la source du premier transistor (PMOS1) lorsque la valeur du mot numérique (DIGW) est supérieure au premier seuil (S1), de manière à limiter la tension drain-source du premier transistor (PMOS1) quelle que soit la valeur dudit mot numérique,
- appliquer une tension proche d'une tension du signal analogique sur la source du troisième transistor (NMOS1) de type NMOS (NN) lorsque la valeur du mot numérique (DIGW) est inférieure à un deuxième seuil (S2), et une tension (VDD) correspondant à une tension maximale délivrée par le convertisseur numérique-analogique (MDAC) sur la source du troisième transistor (NMOS1) lorsque la valeur du mot numérique (DIGW) est supérieure au deuxième seuil (S2), le deuxième seuil (S2) étant inférieur au premier seuil (S1), de manière à limiter la tension drain-source du troisième transistor (NMOS1) quelle que soit la valeur dudit mot numérique (DIGW).

6. Circuit intégré selon l'une des revendications 1 à 5, dans lequel le circuit de contrôle de tensions comprend :
- un premier commutateur (M1a) présentant une première borne connectée à la source du premier transistor (PMOS1) et une deuxième borne connectée à la masse (GND), ce commutateur (M1a) étant contrôlé par un premier signal (Dyn_P),
- un deuxième commutateur (M2a) présentant une première borne connectée à la première borne du circuit de commutation (SWDAC) et une deuxième borne connectée à la source du premier transistor (PMOS1), ce commutateur (M2a) étant contrôlé par le premier signal (Dyn_P),
- un troisième commutateur (M3a) présentant une première borne connectée à la source du troisième transistor (NMOS1), et une deuxième borne configurée pour recevoir une tension (VDD) correspondant à une tension maximale délivrée par le convertisseur numérique-analogique (MDAC), ce commutateur (M3a) étant contrôlé par un deuxième signal (Dyn_N) inversé,
- un quatrième commutateur (M4a) présentant une première borne connectée à la première borne du circuit de commutation (SWDAC) et une deuxième borne connectée à la source du troisième transistor (NMOS1), ce commutateur (M4a) étant contrôlé par le deuxième signal (Dyn_N),
- un circuit de commande (DEC) configuré pour générer le premier signal (Dyn_P) et le deuxième signal (Dyn_N) en fonction de la valeur du mot numérique (DIGW), de manière à limiter la tension drain-source du premier transistor (PMOS1) et la tension drain-source du troisième transistor (NMOS1) quelle que soit la valeur dudit mot numérique.

7. Circuit intégré selon l'une des revendications 1 à 5, dans lequel le circuit de contrôle de tension comprend :
- un premier commutateur (M1b) présentant une première borne connectée à la source du premier transistor (PMOS1) et une deuxième borne connectée à la masse (GND), ce commutateur (M1b) étant contrôlé par un premier signal (Dyn_P),
- un premier amplificateur opérationnel (AOP1) présentant une entrée non inverseuse connectée à la première borne du circuit de commutation (SWDAC), une sortie connectée à la source du premier transistor (PMOS1) et à une entrée inverseuse de ce premier amplificateur opérationnel (AOP1), et une entrée d'alimentation commandée par le premier signal (Dyn_P) inversé,
- un deuxième commutateur (M2b) présentant une première borne connectée à la source du troisième transistor (NMOS1), et une deuxième borne configurée pour recevoir une tension (VDD) correspondant à une tension maximale délivrée par le convertisseur numérique-analogique (MDAC) , ce deuxième commutateur (M2b) étant contrôlé par un deuxième signal (Dyn_N) inversé,
- un deuxième amplificateur opérationnel (AOP2) présentant une entrée non inverseuse connectée à la première borne du circuit de commutation (SWDAC), une sortie connectée à la source du troisième transistor (NMOS1) et à une entrée inverseuse de ce deuxième amplificateur opérationnel (AOP2), et une entrée d'alimentation commandée par le deuxième signal (Dyn_N),
- un circuit de commande (DEC) configuré pour générer le premier signal (Dyn_P) et le deuxième signal (Dyn_N) en fonction de la valeur du mot numérique (DIGW), de manière à limiter la tension drain-source du premier transistor (PMOS1) et la tension drain-source du troisième transistor (NMOS1) quelle que soit la valeur dudit mot numérique.

8. Circuit intégré selon l'une des revendications 1 à 5, dans lequel le circuit de contrôle de tension comprend un convertisseur numérique-analogique auxiliaire (ADAC) configuré pour appliquer des tensions sur la source du premier transistor (PMOS1) et sur la source du troisième transistor (NMOS1) en fonction de la valeur du mot numérique (DIGW) de manière à limiter la tension drain-source du premier transistor (PMOS1) et la tension drain-source du troisième transistor (NMOS1) quelle que soit la valeur dudit mot numérique.

9. Circuit intégré selon la revendication 8, dans lequel le convertisseur numérique-analogique auxiliaire (ADAC) comprend :
- un circuit diviseur de tension (VDIV) configuré pour générer des tensions proches d'une tension (VDD) correspondant à une tension maximale délivrée par le convertisseur numérique-analogique (MDAC) et des tensions proches de la masse (GND),
- un premier groupe de commutateurs (M11, M12, M13, M14, M15) configuré pour appliquer lesdites tensions proches de la masse ou la tension maximale (VDD) sur la source du premier transistor (PMOS1),
- un deuxième groupe de commutateurs (M21, M22, M23, M24, M25) configuré pour appliquer lesdites tensions proches de la tension maximale (VDD) ou la tension de la masse (GND) sur la source du troisième transistor (NMOS1),
- un circuit de commande (DEC) pour commander les commutateurs du convertisseur-analogique auxiliaire (ADAC) selon la valeur du mot numérique (DIGW) de manière à limiter la tension drain-source du premier transistor (PMOS1) et la tension drain-source du troisième transistor (NMOS1) quelle que soit la valeur dudit mot numérique.

10. Circuit intégré selon la revendication 8, dans lequel le convertisseur numérique-analogique auxiliaire (ADAC) comprend :
- une première paire de commutateurs (M11, M12) configurée pour appliquer une tension (VDD) correspondant à une tension maximale délivrée par le convertisseur numérique-analogique (MDAC) ou une tension de masse (GND) sur la source du premier transistor (PMOS1)
- une deuxième paire de commutateurs (M21, M22) configurée pour appliquer la tension maximale (VDD) ou une tension de masse (GND) sur la source du troisième transistor (NMOS1),
- un circuit de commande (DEC) pour commander les paires de commutateurs du convertisseur-analogique auxiliaire (ADAC) selon la valeur du mot numérique (DIGW) de manière à limiter la tension drain-source du premier transistor (PMOS1) et la tension drain-source du troisième transistor (NMOS1) quelle que soit la valeur dudit mot numérique.
